Europäisches Patentamt

European Patent Office

Office européen des brevets

(11) Veröffentlichungsnummer: **0 499 945 A2**

(19)

# EUROPÄISCHE PATENTANMELDUNG

(12)

(21) Anmeldenummer: **92102243.0**

(22) Anmeldetag: **11.02.92**

(51) Int. Cl.5: **H03K 17/96**

(30) Priorität: **19.02.91 DE 4105081**

(43) Veröffentlichungstag der Anmeldung:
**26.08.92 Patentblatt 92/35**

(84) Benannte Vertragsstaaten:
**AT BE CH DE ES FR GB IT LI NL**

(71) Anmelder: **Braun Akfiengesellschaft**
**Rüsselsheimer Strasse 22**

**W-6000 Frankfurt/Main(DE)**

(72) Erfinder: **Beerwerth, Frank, Dr.**
**Im Weiherfeld 16**
**W-6246 Glashütten 2(DE)**
Erfinder: **Schmidt, Hartmut, Dr.**
**Pommernstrasse 16**
**W-6200 Wiesbaden(DE)**

(54) **Optoelekfronischer Berührungssensor.**

(57) Der optoelektronische Berührungssensor (1) besteht aus einem Lichtleiter (4) mit einer ersten (5) und zweiten (6) Oberfläche, mit einer die erste (5) Oberfläche bestrahlenden Strahlungsquelle (7) und mit einem in optischem Kontakt mit der Austrittsfläche (3) stehenden strahlungsempfindlichen Empfänger (8). Die Intensität der auf den Empfänger (8) auftreffenden Strahlung nimmt deutlich zu, wenn ein die von der betreffenden Strahlungsquelle abgegebene Strahlung remittierender Gegenstand in direkten Kontakt mit der zweiten Oberfläche (6) gebracht wird. Nach der Erfindung wird zwischen der Austrittsfläche (3) und dem Empfänger (8) ein weiterer Lichtleiter (14) angeordnet, wobei beide Lichtleiter (4, 14) so gegeneinander abgewinkelt sind, daß die Strahlungsquelle (7) und der Empfänger (8) auf einer der ersten (5) Oberfläche gegenüberliegenden Ebene liegen. Diese Anordnung hat den Vorteil, daß sowohl der Empfänger (8) als auch die Strahlungsquelle (7) sowie weitere für den Betrieb des Berührungssensors (1) notwendige elektronische Bauelemente auf einer einzigen Leiterplatte (19) angeordnet werden können.

Fig. 1

EP 0 499 945 A2

Die Erfindung betrifft einen optoelektronischen Berührungssensor nach dem Oberbegriff des Patentanspruchs 1.

Aus der US-PS 4,254,333 ist ein optoelektronischer Berührungssensor bekannt, dessen wesentliche Bauteile aus einem Lichtleiter, einer Leuchtdiode und einem Fototransistor bestehen, wobei die Leuchtdiode über eine Treiberschaltung angesteuert und die vom Fototransistor empfangenen Lichtsignale von einer Auswerteschaltung analysiert werden. Nach der Fig. 1 der US-PS 4,254,333 besteht die räumliche Anordnung von Leuchtdiode und Fototransistor darin, daß das von der Leuchtdiode ausgesandte Licht an einer im folgenden als Eintrittsfläche bezeichneten Schmalseite des Lichtleiters eingekoppelt, danach innerhalb des Lichtleiters durch ein- oder mehrfache Totalreflexion an seiner ersten und zweiten Oberfläche weitergeleitet wird und schließlich nur unwesentlich abgeschwächt an der anderen, im folgenden als Austrittsfläche bezeichneten Schmalseite des Lichtleiters wieder austritt, die ihrerseits wiederum in gutem optischen Kontakt mit dem Fototransistor steht.

Das Arbeitsprinzip dieses optoelektronischen Berührungssensors besteht darin, daß dann, wenn entweder mit der ersten oder mit der zweiten Oberfläche des optoelektronischen Berührungssensors ein Körperteil, beispielsweise ein Finger eines Benutzers, in Kontakt gebracht wird, das an der Austrittsfläche austretende Licht geschwächt wird. Die Gründe für die Abschwächung des Lichts beruhen auf einer Aufhebung der Totalreflexion an der Berührungsstelle im Lichtleiter und sind im einzelnen in M. Born und E. Wolf: "Principles of Optics", Pergamon Press 1959, Seite 47-49 oder auch in A. I. Mahan und C.V. Bitterli, Applied Optics 17, Seite 509 (1978) dargelegt. Die auftretende Lichtabschwächung wird von der Auswerteschaltung als Kriterium für eine Berührung einer der beiden Oberflächen des Lichtleiters benutzt und dann in die gewünschte Schaltfunktion umgesetzt.

Ein wesentlicher Nachteil des aus Fig. 1 der US-PS 4,254,333 bekannten optoelektronischen Berührungssensors besteht darin, daß zur Erkennung einer Berührung eine kleine Verringerung der Intensität eines großen Lichtsignals detektiert werden muß, weil am Fototransistor bei Nichtberührung die maximale Lichtintensität anliegt. Diese Art des Aufbaus eines optoelektronischen Sensors erfordert einen genauen und für jedes Bauteil getrennt durchzuführenden Abgleich, der in einer Großserienproduktion aufgrund der damit verbundenen Kosten nicht erwünscht ist.

Der in Fig. 2 der US-PS 4,254,333 gezeigte optoelektronische Berührungssensor weist einen anderen prinzipiellen Aufbau auf, da das von der Leuchtdiode ausgesandte Licht nicht mehr in die Eintrittsfläche des Lichtleiters eingekoppelt wird, sondern auf dessen erste Oberfläche gerichtet ist. Unter der Voraussetzung, daß sowohl die Eintrittsfläche des Lichtleiters als auch der Fototransistor selbst gegen einen direkten. von der Leuchtdiode ausgehenden Lichteinfall abgeschirmt ist, tritt an der Austrittsfläche des Lichtleiters nur noch ein kleiner Bruchteil der von der Leuchtdiode abgegebenen Lichtmenge aus. Diese Lichtmenge wird dann erhöht, wenn die der Leuchtdiode gegenüberliegende zweite Oberfläche wiederum beispielsweise mit einem Finger berührt wird. Es wird dann nämlich Licht, welches ansonsten aus der zweiten Oberfläche austreten würde, durch Remission an dem Finger in allen Richtungen in den Lichtleiter zurückgeworfen. Unter den eintretenden Lichtstrahlen sind auch solche vorhanden, die die Bedingung für eine Totalrefexion in Bezug auf die beiden Oberflächen erfüllen, wodurch sich an der Lichtaustrittsfläche eine erhöhte Intensität ergibt.

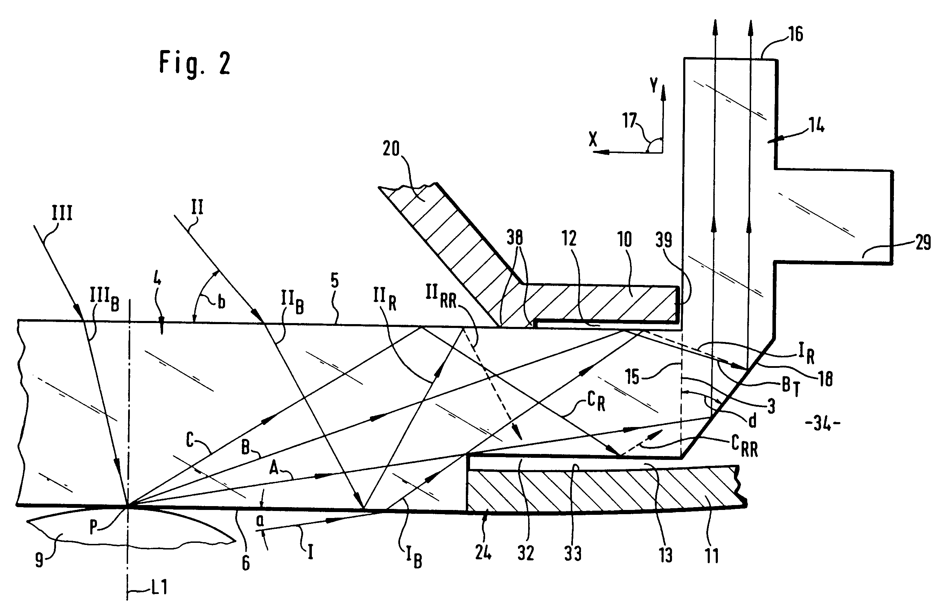

Ein wesentlicher Nachteil der Anordnung nach Fig.2 ist es, daß der Lichtleiter in der Nähe des Photodetektors eine Abdeckung benötigt, die verhindert, daß der Sensor bündig in einen Handgriff integriert werden kann. Darüber hinaus ist die Ankopplung der optoelektronischen Bauteile an den Lichtleiter stets mit hohem mechanischen Aufwand verbunden und erfordert kritische Abgleicheinstellungen, was eine Serienfertigung erheblich verteuert.

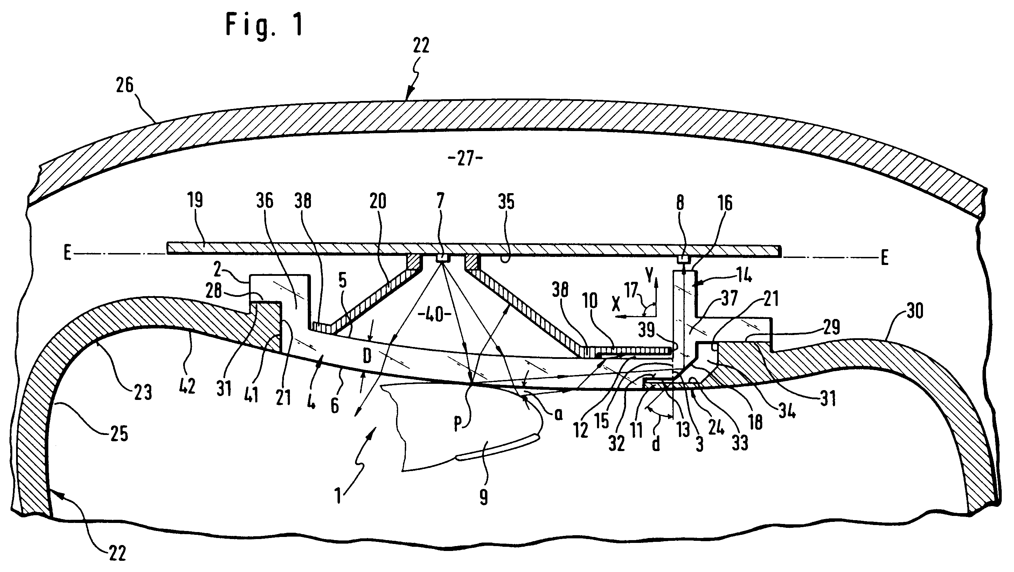

Auch die aus der WO 84/03186 bekannte Anordnung weist den Nachteil auf, daß sie eine Abdeckung benötigt, die es verhindert, daß der optoelektronische Berührungssensor als Ganzes bündig in eine Gehäusefläche oder einen Handgriff eines Gerätes eingebaut werden kann. Dies gilt besonders für die Ausführungsform nach Fig. 2, die eine besonders großflächig wirkende Abdeckung erforderlich macht. Bei der Ausführungsform nach Fig. 1 kann zwar eine kleinflächigere, die Kanten aber dennoch deutlich störende Abdeckung verwendet werden. Es muß allerdings der Nachteil in Kauf genommen werden, daß der Detektor nur in einiger Entfernung von der Austrittsfläche des Lichtleiters angebracht werden kann, eine Maßnahme, die die Baulänge der gesamten Anordnung erhöht. Darüber hinaus wird bei der Ausführungsform nach Fig. 1 Streustrahlung zwar am Detektor vorbeigeführt, sie tritt aber in den den Detektor umschließenden Raum ein und kann nach merhmaliger Reflexion schließlich doch unerwünschterweise auf den Detektor gelangen.

Der in der DE 37 15 497 Al beschriebene Aufbau eines optoelektronischen Berührungssensors hat den Zweck, die Berührung einer Benutzerhand zu detektieren und dementsprechend ein elektrisches Gerät, insbesondere ein Bügeleisen, ein - bzw. auszuschalten. Zur eindeutigen Erkennung der Berührung wird sowohl von der Benutzerhand reflektiertes Licht als auch das Umgebungslicht benutzt. Dies bedeutet, daß für den Betrieb der Schaltung Parameter (Beleuchtungsstärke des Umgebungslichtes) von Bedeutung sind, die nicht im Einflußbereich der elektronischen Schaltung liegen bzw. nichts mit der zu detektierenden Berührung zu tun haben. Eine Fehlinterpretation der Signale ist daher bei diesem Aufbau nicht auszuschließen.

Somit liegt der Erfindung die Aufgabe zugrunde, einen optoelektronischen Berührungssensor anzugeben, der unabhängig von der Intensität der Umgebungsstrahlung zuverlässig arbeitet, selektiv auf die Berührung der menschlichen Hand reagiert, der sich bündig in die Gestalt eines ihn umgebenden Handgriffs einarbeiten läßt, der sich ohne aufwendigen elektrischen Abgleich und einfach und damit auch kostengünstig in Serienfertigung montieren läßt.

Für einen optoelektronischen Berührungssensor nach dem Oberbegriff des Patentanspruchs 1 wird diese Aufgabe durch die im kennzeichnenden Teil dieses Patentanspruchs aufgeführten Merkmale gelöst.

Die erfindungsgemäße Ausbildung des optoelektronischen Berührungssensors bietet zunächst den Vorteil, daß die durch die Geometrie des Lichtleiters bedingten grundsätzlichen Beschränkungen in der räumlichen Anordnung von Strahlungsquelle und Empfänger wieder weitgehend aufgehoben werden, so daß der optoelektronische Berührungssensor leicht in die verschiedensten Geräte unter Ausnutzung der bei diesen vorhandenen Platzmöglichkeiten eingebaut werden kann. Dies wird insbesondere dadurch erreicht, daß die beiden Lichtleiter gegeneinander abgewinkelt sind.

Ein weiterer Vorteil des erfindungsgemäßen optoelektronischen Berührungssensors besteht darin, daß sowohl die Strahlungsquelle als auch der Empfänger auf einer gemeinsamen Leiterplatte angebracht werden können, die darüberhinaus weitere elektronische Bauteile des optoelektronischen Berührungssensors tragen kann. Auf diese Weise wird ein kompakter und damit platzsparender Aufbau des optoelektronischen Berührungssensors erreicht. Weiterhin ist es dadurch möglich, sowohl eine als Strahlungsquelle dienende Leuchtdiode als auch den als Fototransistor ausgebildeten Empfänger in der heute bevorzugten SMD-Technik auf der Leiterplatte anzubringen, was mit erheblichen Kostenvorteilen und mit einem platzsparenden Schaltungsaufbau verbunden ist.

Eine dem Patentanspruch 2 entsprechende Weiterbildung der Erfindung bildet gleichzeitig mehrere Vorteile. Zum einen handelt es sich bei Plexiglas um ein relativ billiges Material für den Lichtleiter, welches mit einem Brechungsindex von 1,55 bis zu einem Grenzwinkel von etwa 40° für einen auf eine der beiden Oberflächen auftretenden Lichtstrahl immer noch Totalrefexion erlaubt. Dies ist dann von Bedeutung, wenn die zweite Oberfläche beispielsweise mit einem Finger berührt wird und die von diesem durch Remission ausgehenden Lichtstrahlen noch bis zu einem Eintrittswinkel von etwa 40° durch Totalreflexion immer noch nahezu ungeschwächt zur Austrittsfläche gelangen, was mit einem besonders großen Signalanstieg am Empfänger verbunden ist.

Zum anderen läßt sich mit dem in Plexiglas geltenden Grenzwinkel für das Auftreten von Totalrefexion die geforderte 45° - Strahlablenkung mit einem recht gutem Wirkungsgrad bewältigen. Dies gilt deshalb, weil auch noch ein beträchtlicher Anteil schräg aus aus der Austrittsfläche des Lichtleiters austretende und daher unterhalb eines Winkel von 45° auf die Umlenkfläche des weiteren Lichtleiters auftreffende Lichtstrahlen noch durch Totalreflexion umgelenkt werden können.

Plexiglas eignet sich ferner aufgrund seiner Elastizität auch sehr gut für einen wieder lösbaren Einbau in das Gehäuse eines Geräts ("Einklipsen"), welches beispielsweise mit Hilfe des optoelektronischen Berührungssensors ein- und ausgeschaltet werden kann. Daneben läßt es sich leicht bearbeiten, so daß die für einen Einbau in das Gehäuse eines bestimmten Geräts notwendige individuelle Formgebung eines bereits in Großserie vorgefertigten Lichtleiters leicht durchführbar ist.

Der optoelektronische Berührungssensor läßt sich vorteilhaft bei einem Bügeleisen anwenden (vgl. Anspruch 3), dessen Spannungsversorgung nur bei Berührung seiner zweiten Oberfläche aufrecht erhalten wird. Damit können die bekannten Gefahren vermieden werden, die von eingeschalteten und in Bügelstellung zurückgelassenen Bügeleisens aus gehen.

Durch die Merkmale des Patentanspruchs 4 ergibt sich ein nahtloser Übergang des Lichtleiters zur Kontur des Handgriffs, so daß auch bei in den Übergangsbereich einwirkendem Spritzwasser dieses nicht in den Innenraum des Handgriffs eindringt.

Durch die Merkmale des Patentanspruchs 5 ist der Lichtleiter nicht direkt der Sonneneinstrahlung ausgesetzt, so daß Fehlmessungen am Sensor ausgeschlossen sind. Des weiteren ergibt sich der Vorteil, daß anders als bei einem an der Oberseite des Handgriffs ausgebildeten Fenster, durch ein unbeabsichtigtes Auflegen eines Gegenstandes, beispielsweise eines zu bügelnden Stoffes, nicht die gleiche Wirkung eintritt, wie wenn man dieses Fenster berührt. Durch die Anbringung des Lichtleiters unterhalb des Handgriffs ergibt sich auch der Vorteil, daß die äußere Kontur des Bügeleisens, also die üblicherweise erkennbare Ansicht des Bügeleisens geschlossen ist und nicht durch das Fenster unterbrochen ist.

Bildet man den Lichtleiter im Bereich seiner Eintrittsfläche nach Anspruch 6 aus, so stellt dies eine einfache Methode dar, dessen ursprüngliche Eintrittsfläche von dessen Austrittsfläche "abzukoppeln", da an ersterer eintretendes Licht nicht um 90° umgelenkt werden kann und die dadurch gebildete neue Eintrittsfläche weitgehend lichtdicht gegen das Gehäuse des Bügeleisens anliegt. Ein derart ausgebildeter optoelektronischer Berührungssensor hat darüber hinaus aber auch den Vorteil, daß er sich sehr gut dafür eignet, im Gehäuse leicht verrastet oder "eingeklipst" und damit wieder leicht lösbar befestigt zu werden. Die bei einer Ausführungsform nach Anspruch 6 gebildete Flanschfläche kann rund umlaufen und damit auch zur Befestigung des Lichtleiters dienen.

Dadurch, daß sowohl die erste als auch die zweite Oberfläche im Bereich der Austrittsfläche mit einer aus lichtundurchlässigem Material bestehenden ersten und zweiten Abdeckung versehen sind (Anspruch 7), kann unter flachem Winkel auf die erste oder zweite Oberfläche einfallendes Licht nicht an der Austrittsfläche austreten, ohne vorher zumindest einmal im Lichtleiter reflektiert worden zu sein. Weiterhin kann unter steilerem Winkel auf die erste oder zweite Oberfläche einfallendes Licht, sei es nun Fremdlicht oder von der Lichtquelle selbst ausgehendes Licht erst nach mehrmaliger Reflexion innerhalb des Lichtleiters an der Austrittsfläche austreten.

Da es sich unabhängig davon, ob das von der Lichtquelle selbst oder von einer Fremdlichtquelle ausgehende Licht unter flachem oder steilerem Winkel auf die erste oder zweite Oberfläche einfällt, innerhalb des Lichtleiters nur Lichtstrahlen auftreten, deren Ein- und Ausfallwinkel kleiner als der Grenzwinkel der Totalreflexion ist, tritt an der ersten und zweiten Oberfläche immer sowohl eine Brechung als auch eine Reflexion der entsprechenden Lichtstrahlen auf. Beim Eintritt in den Lichtleiter behält der betreffende Lichtstrahl, da es sich dabei um einen Übergang vom optisch dünneren in das optisch dichtere Medium handelt, den Großteil seiner Intensität bei. Beim Austritt eines Lichtstrahls aus dem Lichtleiter verhalten sich die Intensitäten von gebrochenem und reflektiertem Strahl ebenso, da zwischen beiden Abdeckungen ein Luftspalt besteht. Für den im Lichtleiter verbleibenden Anteil des Lichts bedeutet dies eine beträchtliche Schwächung, die sich bei jeder erneuten Aufteilung in einen gebrochenen austretenden und in einen reflektierten im Lichtleiter verbleibenden Lichtanteil wiederholt.

Auf diese Weise werden unter steilerem Winkel einfallende Lichtanteile aufgrund der Tatsache, daß sie wegen der Existenz der beiden Abdeckungen nur in einer gewissen Entfernung von der Austrittsfläche durch eine der beiden Oberflächen der beiden Lichtleiter eintreten können, in diesen mehrfach reflektiert und somit stark geschwächt.

Unter flachem Winkel einfallende Lichtanteile können wiederum aufgrund der Abdeckung nur in einer solchen Entfernung von der Austrittsfläche auf eine der beiden Oberflächen einfallen, daß sie nicht direkt auf die Austrittsfläche gebrochen werden, sondern zumindest einmal reflektiert und daher aufgrund der Existenz des Luftspaltes in ihrer Intensität auch entscheidend geschwächt werden.

Da aufgrund der üblichen Strahlungscharakteristik unter flachem Winkel einfallendes Licht eine wesentlich geringere Intensität aufweist als unter steilerem Winkel einfallendes Licht, genügt zur entscheidenden Abschwächung der Intensität im ersten Fall ein einzige Reflexion innerhalb des Lichtleiters, um in etwa dieselbe Abschwächung zu erreichen, die bei unter steilerem Winkel einfallendem Licht erst nach mehrmaliger Reflexion erreicht wird.

Als Folge der kennzeichnenden Merkmale des Patentanspruchs 1 ergibt sich daher auf einfachste und damit auch sehr kostengünstige Weise ein optoelektronischer Berührungssensor, dessen strahlungsempfindlicher Empfänger ohne Berührung seiner zweiten Oberfläche kaum von Licht beaufschlagt wird und der demzufolge bei deren Berührung ein relativ stark ansteigendes Signal detektiert. Durch die erfindungsgemäße Ausgestaltung des elektrooptischen Berührungssensors wird also dessen Empfindlichkeit beträchtlich erhöht.

Um zusätzliche Bauteile zu vermeiden und gleichzeitig eine stabile Lage der zweiten Abdeckung zu erhalten ist in einer Weiterbildung der Erfindung vorgesehen (Anspruch 8), daß ein Wandabschnitt des Randes der Öffnung gleichzeitig auch die zweite Abdeckung bildet.

Bildet man die Erfindung gemäß Anspruch 9 weiter, so wird erreicht, daß an der ersten oder zweiten Oberfläche im Bereich der beiden Abdeckungen in den zugehörigen Luftspalt austretendes Licht nicht durch die Abdeckung selbst wieder teilweise remittiert wird und dadurch wieder in den Lichtleiter eintritt. Dies hat den Vorteil, daß auf eine der beiden Oberflächen einfallendes Licht durch die Abdeckung besonders wirkungsvoll unterdrückt wird, was die Empfindlichkeit des optoelektronischen Berührungssensors weiter erhöht.

Wird die Lichtquelle gemäß den Merkmalen des Patentanspruchs 10 von einem lichtundurchlässigen Tubus seitlich abgeschottet, so kann kein von der Lichtquelle ausgehendes Licht in Nähe der Eintritts- und Austrittsöffnung auf den Lichtleiter einfallen. Durch die Bildung des Tubus wird also eine Abschirmung um die Lichtquelle geschaffen, durch die nur derjenige Bereich der beiden Oberflächen mit Licht bestrahlt wird, der für eine Berührung vorgesehen ist.

In einer Weiterbildung der Erfindung (Anspruch 11) ist es besonders vorteilhaft, wenn die Abdeckung direkt am Tubus angeformt ist. Der ohnehin vorteilhafte Tubus dient somit gleichzeitig als Abdeckung für den Lichtleiter, so daß hierdurch zusätzliche Bauteile und besondere Befestigungsmittel vermieden werden.

Ein Ausführungsbeispiel der Erfindung ist in der Figur dargestellt und wird im folgenden näher erläutert. Es zeigen:

Fig. 1    einen Längsschnitt durch den Handgriff eines Bügeleisens und

Fig. 2    einen Teilausschnitt des ersten und zweiten Lichtleiters im Bereich der Umlenkfläche mit einer schematischen Darstellung des Strahlengangs der für die Erfindung wesentlichen Lichtanteile.

In Fig. 1 ist ein Handgriff 22 eines in der Zeichnung nicht näher gezeigten Bügeleisens dargestellt, der mit einer Griffmulde 25 versehen ist, in die zum Führen des Bügeleisens die Finger 9 einer Hand einer Bedienungsperson eingreifen, während der Ballen der Hand (nicht dargestellt) an der Oberseite 26 des Handgriffs 22 anliegt. Der Handgriff 22 besteht aus einem zylindrisch ausgebildeten Hohlkörper, in dessen Innenraum 27 der optoelektronische Berührungssensor 1 ausgebildet ist.

Der Berührungssensor 1 besteht nach Fig. 1 im wesentlichen aus einem Lichtleiter 4 und einem weiteren Lichtleiter 14, die beide ein gemeinsames Teil bilden. Die Lichtleiteranordnung 4, 14 ist in ein an der Unterseite 42 des Handgriffs 22 ausgebildeten Öffnung 21 eingesetzt und verschließt diese bündig, so daß die zur Griffmulde 25 hingerichtete zweite Oberfläche 6 mit der Kontur 23 des Handgriffs 22 eine glatte Oberfläche ohne Übergangskanten bildet. Die Lichtleiter 4, 14 weisen an beiden Enden Flanschflächen 28, 29 auf, die an an der Innenwand 30 des Handgriffs 22 hervorstehenden Auflageflächen 31 anliegen und die über in der Zeichnung nicht dargestellte Befestigungsmittel, beispielsweise Schrauben, mit dem Handgriff 22 im Innenraum 27 befestigt sind. Die Flanschflächen 28, 29 sind über an den Lichtleitern 4, 14 angeformte Winkelstücke 36, 37 mit diesen verbunden. Die Flanschflächen 28, 29 können zusammen mit den Winkelstücken 36, 37 auch so ausgebildet sein, daß sie federnde, in die Öffnung 21 einklipsbare Rastelemente bilden, die nach einem von außen erfolgenden Einsetzen der Lichtleiteranordnung 4, 14 in die Öffnung 21 die Auflagefläche derart hintergreifen, daß die Lichtleiteranordnung 4, 14 fest in der Öffnung 21 gehalten wird. Bei dem in Figur 1 dargestellten Ausführungsbeispiel wird allerdings die Lichtleiteranordnung 4 von oben über den Innenraum 27 in die Öffnung 21 eingesetzt.

An dem in Figur 1 dargestellten rechten Bereich des Lichtleiters 4 ist an der zweiten Oberfläche 6 eine Vertiefung 32 ausgebildet, in die ein von der Öffnung 21 ausgehender Vorsprung 24 eingreift, der die zweite Abdeckung 11 für den Lichtleiter 4 bildet. Die zweite Oberfläche 6 bildet mit der Kontur 23 des Wandabschnittes 24 eine glatte Oberfläche und wird von einer im Querschnitt rechteckigen oder ovalen Fläche, die von der Öffnung 21 und dem Ende der zweite Abdeckung 11 begrenzt wird, gebildet.

Die beiden Oberflächen 5, 6 des Lichtleiters 4 verlaufen nach Fig. 1 und 2 nahezu parallel zueinander und sind in der Zeichnung nach unten gewölbt. Der durch die beiden Oberflächen 5, 6 begrenzte Lichtleiter 4 wird nach Fig. 1 auf der rechten Seite durch die Austrittsfläche 3 begrenzt. An die Austrittsfläche 3 schließt sich einstückig mit dem Lichtleiter 4 der weitere Lichtleiter 14 an, der zum Lichtleiter 4 im wesentlichen senkrecht verläuft. Die Austrittsfläche 3 ist eine gedachte Fläche für den Lichtleiter 4, die zur deutlichen Kennzeichnung in den Fign. 1 und 2 gestrichelt dargestellt wurde und die gleichzeitig für den zweiten Lichtleiter 14 die zweite Eintrittsfläche 15 bildet. Beide Flächen 3, 15 würden körperlich erst dann auftreten, wenn man die beiden Lichtleiter 4, 14 an dieser Stelle trennen würde.

Am Ende des weiteren Lichtleiters 14 ist nach den Fign 1 und 2 eine zweite Austrittsfläche 16 ausgebildet, die, aufgrund der einstückigen Ausbildung des Lichtleiters 4 und des weiteren Lichtleiters 14 zu einem einzigen Bauteil, für die gesamte Lichtleiteranordnung 4, 14 die eigentliche Austrittsfläche bildet. Um alle von der zweiten Eintrittsfläche 15 in den weiteren Lichtleiter 14 eintretenden Strahlen auf die zweite Austrittsfläche 16 umlenken zu können, schließt sich an die zweite Eintrittsfläche 15 eine Umlenkfläche 18 an, die in einem Winkel d zur zweiten Eintrittsfläche 15 verläuft. Die Umlenkfläche 18 erstreckt sich nach den Fign. 1 und 2 über eine Länge, die so bemessen ist, daß die die zweite Eintrittsfläche 15 durchquerenden Lichtstrahlen an der Umlenkfläche 18 aufgrund der hier eintretenden Totalreflexion zur zweiten Austrittsfläche 16 des weiteren Lichtleiters 14 umgelenkt werden.

Der Boden der Vertiefung 32 verläuft nach Fig. 1 und 2 in geringem Abstand zur Oberseite 33 der zweiten Abdeckung 11 so daß an dieser Stelle ein Luftspalt 13 gebildet wird. Zwischen der Umlenkfläche 18 und dem Übergang von der zweiten Abdeckung 11 zur Öffnung 21 ist ein Freiraum 34 ausgebildet.

Oberhalb des Lichtleiters 4 verläuft nach Fig. 1 im Innenraum 27 des Handgriffs 22 eine Leiterplatte 19, deren Ebene E-E sich im wesentlichen in der gleichen Richtung wie der Lichtleiter 4 erstreckt.

Etwa auf der Höhe der Mitte des Lichtleiters 4 ist an der der ersten Außenfläche 5 zugewandten Oberfläche 35 an der Leiterplatte 19 eine Lichtquelle 7 befestigt, die von einem konisch sich zur ersten Außenfläche 5 erweiternden Tubus 20 umgeben ist. Der Tubus 20 ist auf der Leiterplatte 19, beispielsweise durch Verkleben oder Einklipsen, befestigt. Die Leiterplatte 19 ist wiederum über in der Zeichnung nicht dargestellte Befestigungsmittel im Innenraum 27 des Handgriffs 22 befestigt.

Es ist aber auch möglich, daß der Tubus 20 an der ersten Oberfläche 5 des Lichtleiters 4 befestigt ist, so daß dann dieser die Leiterplatte 19 trägt.

Der Tubus 20 weist nach Fig. 1 an seinem der ersten Oberfläche 5 zugewandten Bereich einen sich radial nach außen erweiternden Ringbund 38 auf, der an der ersten Oberfläche 5 bündig anliegt. Nach Fig. 1 schließt sich an das rechte Ende des Ringbundes 38 eine erste Abdeckung 10 an, die unter anderem den unterhalb sich befindenden Abschnitt des weiteren Lichtleiters 14 von Licht abschirmt. Zwischen der weiteren Abdeckung 10 und der ersten Oberfläche 5 ist ein erster Luftspalt 12 ausgebildet. Die erste Abdeckung 10 verläuft mit ihrem freien Ende 39 bis in die Höhe der Austrittsfläche 3 des Lichtleiters 4 bzw. bis in die Höhe der ersten Eintrittsfläche 15 des weiteren Lichtleiters 14, wo auch die Umlenkfläche 18 beginnt.

Nach Fig. 1 ist zwischen der zweiten Austrittsfläche 16 und der Leiterplatte 19 ein Empfänger 8 ausgebildet, der das von der Lichtquelle 7 über die Lichtleiter 4, 14 umgeleitete Licht aufnimmt, wenn an der zweiten Oberfläche 6 ein remittierender Gegenstandes 9, beispielsweise ein oder mehrere Finger 9 einer Hand, aufliegen. Eine in der Zeichnung nicht dargestellte elektronischen Schaltung, die vorteilhafterweise auf der Leiterplatte 19 angeordnet sein kann, verarbeitet dieses Signal entsprechend weiter. Der Empfänger 8 ist ebenfalls auf der Oberfläche 35 der Leiterplatte 19 befestigt und liegt in derselben Ebene E-E wie die Lichtquelle 7.

Nach Fig. 1 ist der Innenraum 27 vollständig vom Handgriff 22 umgeben, so daß auf den Lichtleiter 4 Licht nur über die zweite Oberfläche 6 und aus dem vom Tubus 20 und der ersten Oberfläche 5 gebildeten Raum 40 auftreffen kann. Der Empfänger 8 ist derart lichtdicht eingekapselt, daß auf ihn nur Licht auftreffen kann, welches an der Austrittsfläche 16 des weiteren Lichtleiters 14 austritt. Dies kann beispielsweise dadurch erreicht werden, daß in ein als Schale ausgebildetes Gehäuse die Austrittsfläche 16 des weiteren Lichtleiters 14 eingebettet. Der Verlauf des Lichtleiters 4 gegenüber dem weiteren Lichtleiter 14 wurde so gewählt, daß die Lichtausbreitungsrichtungen X und Y im wesentlichen einen rechten Winkel 17 bilden.

In Fig. 2 wurde nochmals der Übergang vom Lichtleiter 4 zum weiteren Lichtleiter 14 in vergrößerter Darstellung wiedergegeben. Zur Vermeidung von Wiederholungen wurden für entsprechende Bauteile gleiche Bezugszeichen verwendet. Gleichzeitig wird in Fig. 2 der Strahlengang für die wesentlichen Lichtanteile nochmals verdeutlicht.

Die Wirkungsweise des erfindungsgemäßen optoelektronischen Berührungssensors 1 ist folgende:
Zunächst einmal sei vorausgesetzt, daß längs des Lichtleiters 4 nur eine vernachlässigbare Lichtintensität durch Totalreflexion in Richtung auf seine Austrittsfläche 3 transportiert wird. Dies kann dadurch erreicht werden, daß man dafür sorgt, daß auf die Eintrittsfläche 2 (vgl. Fig. 1) des Lichtleiters 4 kein Licht auftreffen kann oder diese mit einem lichtundurchlässigen Überzug versieht.

Um einen besonders empfindlichen optoelektronischen Berühungssensor zu erhalten, werden nach der Erfindung auch solche Lichtanteile - sei es Fremdlicht oder von der Lichtquelle 7 (vgl. Fig. 1) ausgehendes Licht - weitgehend unterdrückt, die über die beiden Oberflächen 5 und 6 in den Lichtleiter 4 eintreten können, wenn die zweite Oberfläche 6 nicht mit einem remittierenden Gegenstand berührt wird. Dadurch wird erreicht, daß bei einer derartigen Berührung der zweiten Oberfläche 6 des Lichtleiters 4 der relative Anstieg der Intensität des auf die Austrittsfläche 3 fallenden Lichtes viel größer ist als ohne Unterdrückung der genannten Lichtanteile.

Das zu unterdrückende Licht läßt sich in zwei prinzipiell unterschiedliche Anteile aufspalten. Zum einen handelt es sich dabei um die in Fig. 2 mit den Bezugszeichen $I$, $I_B$ und $I_R$ und zum anderen um die mit den Bezugszeichen $II$, $II_B$ und $II_R$ bezeichneten Lichtstrahlen, die jeweils nur schematisch dargestellt ein entsprechendes Bündel von Lichtstrahlen repräsentieren. Sowohl der Lichtstrahl $I$, der Fremdlicht darstellt, als auch der Lichtstrahl $II$, der von der Lichtquelle 7 (vgl. Fig. 1) ausgeht, spalten sich bei ihrem Auftreffen auf die zweite bzw. erste Oberfläche 6 bzw. 5 in einen gebrochenen und in einen reflektierten Lichtanteil auf, wobei in Fig. 2 in beiden Fällen nur noch der gebrochene Lichtstrahl $I_B$ bzw. $II_B$ dargestellt worden ist. Die Intenstät der gebrochenen Lichtstrahlen $I_B$ bzw. $II_B$ liegt in beiden Fällen aufgrund des relativ hohen Brechungsindex von Plexiglas (1,55) gegenüber Luft (etwa 1,00) um ein Vielfaches über der Intensität des reflektierten Lichtstrahls. Während der Lichtstrahl $I$ unter einem sehr flachen Winkel a auf die zweite Oberfläche 6 einfällt, ist der Einfallswinkel b des Lichtstrahls $II$ auf die erste Oberfläche 5 wesentlich steiler.

Aus Fig. 2 ist ersichtlich, daß unter flachem Winkel a und im Bereich der zweiten Abdeckung 11 auf den Lichtleiter 4 einfallende Lichtstrahlen so gebrochen werden würden, daß sie direkt auf die Austrittsfläche 3 treffen würden, wenn die zweite lichtundurchlässige Abdeckung 11 nicht vorhanden wäre. In Bezug auf derart auf eine der beiden Oberflächen 5, 6 einfallendes und nach einer Brechung direkt auf die Austrittsfläche 3 hingerichtetes Licht stellen also die beiden Abdeckungen 10 und 11 ein sehr einfaches Mittel dar, derartige Lichtanteile weitgehend auszublenden. Dabei werden bei einer entsprechend großen räumlichen Ausdehnung der beiden Abdeckungen 10 und 11 längs des Lichtleiters 4 auch noch unter sehr flachem Winkel einfallende Strahlen, die nach einer Brechung auf die Austrittsfläche 3 gerichtet wären, noch ausgeblendet.

Die für eine Ausblendung notwendige räumliche Ausdehnung der beiden Abdeckungen 10, 11 hängt dabei selbstverständlich auch von der Dicke D (vgl. Fig. 1) des Lichtleiters 4 ab.

Der in Fig. 2 dargestellte, nicht mehr ausgeblendete und damit tatsächlich gebrochene Lichtstrahl $I_B$ spaltet sich bei seinem Auftreffen auf die erste Oberfläche 5 wieder in einen reflektierten Lichtstrahl $I_R$ und einen nicht mehr dargestellten gebrochenen, in den ersten Luftspalt 12 eintretenden Lichtstrahl auf. Auch in diesem Fall besitzt der gebrochene Lichtstrahl ein Mehrfaches der Intensität des reflektierten Strahls, weil durch die Existenz des ersten Luftspalts 12 für die Intensitätsverteilung wiederum die Brechungsindices von Luft und Plexiglas maßgeblich sind. Der gebrochene Strahl $I_R$ weist also nach nur einmaliger Reflexion innerhalb des Lichtleiters 4 nur noch einen Bruchteil der Eintrittsintensität des Lichtstrahls I auf und wird daher in Fig. 2 nur noch gestrichelt dargestellt.

Da in Bezug auf die Gesamtintensität von einfallendem Licht die Intensität von unter flachem Winkel a einfallendem Licht nur einen geringen Teil ausmacht (übliche Strahlungscharakteristik), ergibt eine einmalige Reflexion von unter flachem Winkel a einfallendem Licht eine weitgehende Unterdrückung unerwünschter derartiger Lichtanteile.

Unter einem steileren Winkel b einfallende Lichtanteile weisen insgesamt betrachtet eine wesentlich höhere Intensität auf, als unter flacherem Winkel a einfallendes Licht. Derartige Lichtanteile werden wiederum von den beiden Abdeckungen 10 und 11 daran gehindert entweder direkt oder nach nur einer einzigen Reflexion an eine der beiden Oberflächen 5, 6 bereits auf die Austrittsfläche 3 zu treffen. Solche Strahlen (vgl. Lichtstrahl II) werden nämlich nach ihrer durch Brechung erfolgendem Eintritt in den Lichtleiter 4 (vgl. Lichtstrahl $II_B$) mindestens zweimal, im allgemeinen aber mehrmals an den Oberflächen 5 und 6 reflektiert (vgl. Lichtstrahl $II_R$ und den gestrichelt dargestellten Lichtstrahl $II_{RR}$), bevor sie auf die Austrittsfläche 3 auftreffen. Da bei jedem Auftreffen auf eine der beiden Oberflächen 5, 6 nur ein Bruchteil der Intensität im reflektierten Strahl verbleibt, tritt auch eine erhebliche Abschwächung von unter steilem Winkel b einfallenden Lichtanteilen ein.

Auch in diesem Fall sorgen also die Abdeckungen 10 und 11 für eine genügende Anzahl von Reflexionen, während die Luftspalte 12 und 13 für die entsprechende Abschwächung von unter einem steilerem Winkel b auf die erste Oberfläche 5 auftreffender Lichtanteile sorgen.

Als Folge der bisher beschriebenen Arbeitsweise des erfindungsgemäßen optoelektronischen Berührungssensors ergibt sich, daß aus der Lichtaustrittsfläche 3 nur ganz wenig Licht austritt, auch wenn die Lichtquelle 7 (vgl. Fig. 1) Licht aussendet. Der optoelektronische Berührungssensor ist damit sehr empfindlich gemacht worden, da zusätzliches auf die Austrittsfläche 3 auffallendes Licht einen beträchtlichen relativen Intensitätsanstieg verursachen würde. Derartiges zusätzliches Licht (vgl. den von der Lichtquelle 7 ausgehenden Lichtstrahl III, der als Lichtstrahl $III_B$ gebrochen wird und auf den Berührungspunkt P des Fingers 9 mit der zweiten Oberfläche trifft) tritt auf, wenn die zweite Oberfläche 6 mit einem diffus remittierenden Körper, beispielsweise mit einem Finger 9, berührt wird. Durch den unmittelbaren Kontakt von Finger 9 und zweiter Oberfläche 6 besteht im Bereich intensiver Berührung kein optischer Übergang mehr zwischen Luft und Plexiglas. Das heißt, am Berührungspunkt P des Fingers 9 diffus remittiertes Licht tritt ohne Brechung unter dem Winkel, mit dem es vom Finger 9 remittiert wird, in den Lichtleiter ein. Damit sind alle möglichen Eintrittswinkel denkbar, während bei einer Brechung an Plexiglas nur Eintrittswinkel auftreten können, die kleiner oder höchstens gleich etwa 40° sind.

So weist der Strahl A gegen das Lot L1 einen so großen Eintrittswinkel auf, daß er direkt auf die Austrittsfläche 3 trifft. Der Strahl B weist gegen das Lot L1 einen so großen Eintrittswinkel (größer oder gleich etwa 40°) auf, daß er noch die Bedingung für Totalreflexion an der ersten Oberfläche 5 des Lichtleiters 4 erfüllt. Er wird damit als Strahl $B_T$ auf die Austrittsfläche 3 total reflektiert. Sowohl der Strahl A als auch der Strahl B tragen damit zu einem sprunghaften Anstieg der Intensität des auf die Austrittsfläche 3 auftreffenden Lichtes bei.

Der erfindungsgemäße optoelektronische Berührungssensor reagiert auf eine Berührung seiner zweiten Oberfläche 6 daher mit einem sprunghaften Anstieg der auf die Austrittsfläche 3 auftreffenden Lichtintensität.

Lediglich der Strahl C weist gegen das Lot L1 einen so kleinen Eintrittswinkel (kleiner etwa 40°) auf, daß er an der ersten Oberfläche 5 in einen reflektierten Strahl $C_R$ und in einen nicht dargestellten, gebrochenen austretenden Strahl aufgeteilt wird, wobei der Strahl $C_R$ aus den bereits mehrfach erwähnten Gründen nur noch einen Bruchteil der Intensität des ursprünglichen Strahls C besitzt und nach der zweiten Reflexion daher nur noch als gestrichelter Lichtstrahl $C_{RR}$ dargestellt ist.

Sämtliches auf die Austrittsfläche 3 auffallende Licht tritt über die Eintrittsfläche 15 in den weiteren Lichtleiter 14 ein und wird durch die gegen die Austrittsfläche 3 um 45° (Winkel d) geneigte. Umlenkfläche 18 gegen ihre ursprüngliche Ausbreitungsrichtung X um 90° in ihre neue Ausbreitungsrichtung Y umgelenkt. Dadurch, daß in Plexiglas auch Auftreffwinkel bis zu einem unteren Wert von etwa 40° noch zur Totalreflexion führen, wird auch noch ein Großteil der nicht unter 45° auf die Umlenkfläche 18 auftreffenden Lichtstrahlen auf die Austrittsfläche 16 des weiteren Lichtleiters 14 umgelenkt. Der dort angebrachte Empfänger 8 (Fig. 1) detektiert daher bei einer Berührung der zweiten Oberfläche 6, beispielsweise mit einem Finger 9, einen sprunghaften Anstieg der Lichtintensität.

Selbstverständlich kann anstelle der Lichtquelle 17 auch eine Infrarotstrahlung abgebende Quelle, beispielsweise eine Infrarotsendediode verwendet werden. In diesem Fall muß dann als Empfänger ein infrarotempfindliches Bauteil, beispielsweise eine im infraroten Strahlungsbereich empfindliche Empfängerdiode verwendet werden.

## Patentansprüche

1. Optoelektronischer Berührungssensor (1) mit einem eine Austrittsfläche (3) aufweisenden Lichtleiter (4), der darüber hinaus eine erste (5) und eine zweite (6), einander gegenüberliegende, strahlungsdurchlässige und glatte Oberfläche aufweist, mit einer die erste Oberfläche (5) bestrahlenden Strahlungsquelle (7) und mit einem in optischem Kontakt mit der Austrittsfläche (3) stehenden strahlungsempfindlichen Empfänger (8), wobei die Strahlungsquelle (7) so angeordnet ist, daß Strahlung weder auf die Eintrittsfläche (2) des Lichtleiters (4) noch direkt auf den Empfänger (8) einfallen kann und wobei die Intensität der aus der Austrittsfläche (3) des Lichtleiters (4) austretenden Strahlung deutlich zunimmt, wenn ein die Strahlung der Strahlungsquelle (7) remittierender Gegenstand (9) in direktem Kontakt mit der zweiten Oberfläche (6) gebracht wird,
**dadurch gekennzeichnet,**
daß der optische Kontakt zwischen der Austrittsfläche (3) des Lichtleiters (4) und dem Empfänger (8) durch einen weiteren Lichtleiter (14) hergestellt wird, dessen Eintrittsfläche (15) optisch an die Austrittsfläche (3) des Lichtleiters (4) angekoppelt ist, wobei der Empfänger (8) mit der Austrittsfläche (16) des weiteren Lichtleiters (14) in optischem Kontakt steht, daß die beiden Lichtleiter (4, 14) gegeneinander abgewinkelt sind, wobei ihre Strahlungsausbreitungsrichtungen (X bzw. Y) derart zueinander verlaufen, daß die Strahlungsquelle (7) und der Empfänger (8) auf einer der ersten Oberfläche (5) gegenüberliegenden Ebene(E-E) liegen und daß die Ebene (E-E) von einer elektrischen Leiterplatte (19) gebildet wird, die darüber hinaus weitere, für den Betrieb des elektrooptischen Berührungssensor (1) vorgesehene elektronische Bauelemente aufweist.

2. Berührungssensor nach Anspruch 1,
**dadurch gekennzeichnet,**
daß beide Lichtleiter (4, 14) einstückig aus Plexiglas (PMMA) geformt sind und so gegeneinander abgewinkelt sind, daß zwischen ihren Strahlungsausbreitungsrichtungen (X bzw. Y) ein rechter Winkel (17) eingeschlossen wird, der durch eine jeweils um 45° gegen beide Strahlungsausbreitungsrichtungen (X, Y) geneigte, total reflektierende Umlenkfläche (18) erzielt wird.

3. Berührungssensor nach Anspruch 2,
**dadurch gekennzeichnet,**
daß dieser Bestandteil des Gehäuses (22) eines elektrischen Bügeleisens ist, das dann mit seiner Spannungsversorgung verbunden wird, wenn der remittierende Gegenstand (9), beispielsweise die Hand eines Benutzers, mit der zweiten Oberfläche (6) in Kontakt gebracht wird.

4. Berührungssensor nach Anspruch 3,
**dadurch gekennzeichnet,**
daß dieser in einer Öffnung (21) des Handgriffs (22) des Bügeleisens derart untergebracht ist, daß die zweite Oberfläche (6) mit der Kontur (23) des Handgriffs (22) zusammenfällt.

5. Berührungssensor nach Anspruch 4,
**dadurch gekennzeichnet,**
daß die Öffnung (21) derart am Handgriff (22) angeordnet ist, daß die zweite Oberfläche (6) des Lichtleiters (4) zum Bügelgut hin gerichtet ist.

6. Berührungssensor nach Anspruch 4,
**dadurch gekennzeichnet,**
daß der Lichtleiter (4) in Nähe der Öffnung (21) des Handgriffs (22) zunächst um etwa einen rechten Winkel als Winkelstück (36) abgeknickt verläuft und in seinem weiteren Verlauf einen zweiten Knick aufweist, der so ausgebildet ist, daß der Lichtleiter (4) sich danach im wesentlichen wieder in seiner ursprünglichen Richtung weiter erstreckt.

**7.** Berührungssensor nach Anspruch 4,
**dadurch gekennzeichnet,**
daß sowohl die erste (5) als auch die zweite (6) Oberfläche im Bereich der Austrittsfläche (3) soweit mit einer aus strahlungsundurchlässigem Material bestehenden ersten (10) und zweiten (11) Abdeckung versehen sind, daß in Nähe der Austrittsfläche (3) unter flachem Winkel (a) auf die erste (5) oder zweite (6) Oberfläche einfallende Strahlung zumindest einmal und unter steilerem Winkel (b) auf die erste (5) oder zweite (6) Oberfläche einfallende Strahlung mehrmals im Lichtleiter (4) reflektiert wird, bevor es an der Austrittsfläche (3) austritt und daß zwischen der ersten (5) und der zweiten (6) Oberfläche und der zugehörigen ersten (10) und zweiten (11) Abdeckung jeweils ein Luftspalt (12, 13) ausgebildet ist.

**8.** Berührungssensor nach Anspruch 7,
**dadurch gekennzeichnet,**
daß ein Wandabschnitt (24) des Randes der Öffnung (21) gleichzeitig auch die zweite Abdeckung (11) bildet.

**9.** Berührungssensor nach Anspruch 7,
**dadurch gekennzeichnet,**
daß die erste (10) und die zweite (11) Abdeckung aus strahlungsabsorbierendem Material besteht oder zumindest auf ihrer der ersten (5) bzw. zweiten (6) Oberfläche zugewandten Seite damit beschichtet ist.

**10.** Berührungssensor nach Anspruch 1,
**dadurch gekennzeichnet,**
daß die Strahlungsquelle (7) von einem strahlungsundurchlässigen Tubus (20) umgeben ist, der sich von der Leiterplatte (19) bis zur ersten Oberfläche (5) erstreckt.

**11.** Berührungssensor nach Anspruch 7 und 10,
**dadurch gekennzeichnet,**
daß an den Tubus (20) die erste Abdeckung (10) angeformt ist.

Fig. 1

EP 0 499 945 A2

Fig. 2